# EUROPEAN PATENT SPECIFICATION

(11) **EP 1 680 527 B1**
(45) Date of publication and mention of the grant of the patent: **21.03.2012**
(21) Application number: 04794409.5
(22) Date of filing: 07.10.2004
(51) Int. Cl.: C23C 14/34, C23C 14/35

(54) **APPARATUS AND PROCESS FOR HIGH RATE DEPOSITION OF RUTILE TITANIUM DIOXIDE**
VORRICHTUNG UND VERFAHREN ZUR SCHNELLEN ABSCHEIDUNG VON RUTIL-TITANDIOXID
APPAREIL ET PROCEDE POUR LE DEPOT HAUTE VITESSE DE DIOXYDE DE TITANE DE RUTILE

(30) Priority: 07.10.2003 US 508871 P; 07.10.2003 US 508877 P; 17.10.2003 US 512002 P
(43) Date of publication of application: 19.07.2006
(73) Proprietor: DEPOSITION SCIENCES, INC., Santa Rosa California 95403 (US)
(72) Inventor: BOLING, Norman, Santa Rosa, CA 95409 (US); KRISL, Eric, Santa Rosa, CA 95409 (US); GEORGE, Mark, Santa Rosa, CA 95404 (US); RAINS, Miles, Santa Rosa, CA 95403 (US); GRAY, Rober, H., Sebastopol, CA 95472 (US)
(74) Representative: Liesegang, Eva
(86) International application number: PCT/US2004/033045
(87) International publication number: WO 2005/035822

(56) References cited:
- EP-A- 0 516 436
- EP-A- 0 655 515
- EP-A- 0 940 481
- EP-A- 0 945 523
- WO-A-96/06203
- WO-A-96/34125
- US-A- 5 660 693
- US-A- 5 849 162
- US-A- 6 090 247
- US-A- 2002 045 073
- US-A1- 2001 006 148
- US-A1- 2002 070 106
- SZCZYRBOWSKI J ET AL: "Some properties of TiO2-layers prepared by mid-frequency and dc reactive magnetron sputtering" JOURNAL OF NON-CRYSTALLINE SOLIDS, NORTH-HOLLAND PHYSICS PUBLISHING. AMSTERDAM, NL, vol. 218, 1 September 1997 (1997-09-01), pages 262-266, XP004095585 ISSN: 0022-3093
- IMAI F ET AL: "Epitaxial growth of titanium oxide thin films on MgO(100) single-crystal substrates by reactive deposition methods" THIN SOLID FILMS, ELSEVIER-SEQUOIA S.A. LAUSANNE, CH, vol. 310, no. 1-2, 21 November 1997 (1997-11-21), pages 184-193, XP004124906 ISSN: 0040-6090

## Description

### BACKGROUND OF THE INVENTION

Multilayer optical coatings typically consist of alternating layers of materials having high and low indices of refraction. In general it is advantageous to form a multilayer coating from high and low index material where the ratio of the high index to the low index is as large as possible. A multilayer coating formed from materials having a larger index ratio may be formed with fewer layers to achieve the same optical performance as a coating formed from materials having a lower index ratio.

Additionally, a multilayer coating having superior optical performance can be achieved using an equal, or fewer, number of layers by replacing one high index material with another high index material having a larger index. The economics of an optical coating process will be determined by the number of layers required to provide a desired optical result, the rate at which such layers can be deposited, and the surface area over which those deposition rates can be achieved. Fewer layers, and therefore a thinner coating, will also be beneficial due to such characteristics as lower stress and/or scatter compared to thicker coatings.

Imai F. et al: Epitaxial growth of titanium oxide thin films on MgO (100) single-crystal substrates by reactive deposition methods", Thin Solid Films, Elsevier-Sequoia S.A. Lausanne, CH, vol. 310, no. 1-2, 21 November 1997 (1997-11-21), pages 184-193, describes a deposition process comprising the step of depositing a monolayer of titanium on a substrate heated at 450°C, and the step of oxidizing said monolayer using molecular oxygen to form a film of titanium oxide.

Metal oxides have found wide use in optical coating applications because they are durable and generally have good transmission in the visible spectrum. Titanium dioxide (TiO₂) has long been recognized as a potentially valuable high index material for optical coating applications because it is durable, visually transparent, and has a higher index than any other suitable metal oxide. However, the use of titanium dioxide has been severely limited due to several manufacturing difficulties. The foremost difficulty results from the fact that titanium dioxide has three naturally occurring crystalline phases: rutile, anatase, and brookite. Under certain conditions it can also be deposited in a non-crystalline, amorphous form. Of these various phases, the rutile phase has the highest, and therefore most desirable, refractive index. Rutile titanium dioxide is birefringent, with an average index of 2.75 at 550 nm and is the most thermodynamically stable phase. A further problem exists in that even when rutile titanium dioxide is deposited, it is often absorbing due to difficulties in oxidizing the film unless the deposition rate is so slow as to be economically impractical.

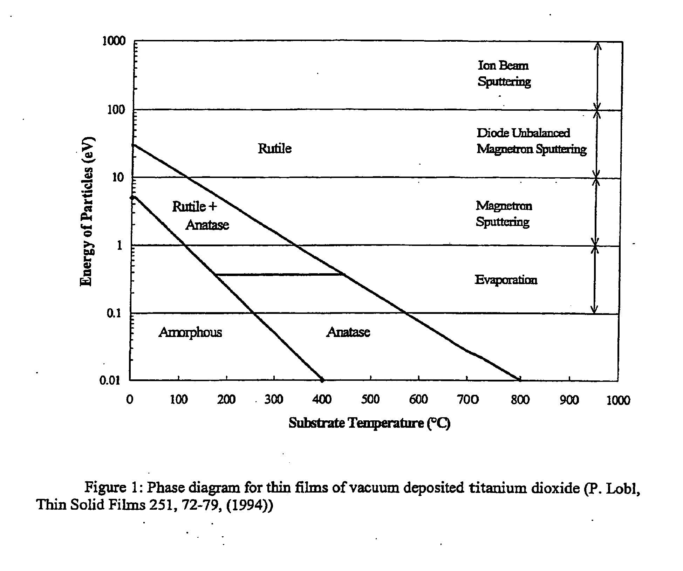

Although the rutile phase is the most thermodynamically stable, it requires very high energies to form rutile titanium dioxide directly during growth of the thin film. The energy required can be supplied by the deposition process, by heating of the substrate, or both. The phase diagram of deposited titanium dioxide as a function of substrate temperature and deposition process has been published and is shown in Figure 1. With reference to Figure 1, it is apparent that low energy deposition techniques require an impractically high substrate temperatures to achieve the deposition of rutile titanium dioxide. Nearly all prior art methods for deposition of thin films of titanium dioxide yield either amorphous, anatase, or a mix of anatase and rutile films. These results are less desirable than obtaining titanium dioxide in substantially all rutile phase because the refractive index of the anatase phase is substantially lower (n= 2.45 @ 550 nm) than that of the rutile phase. Heating of the anatase or amorphous phases to temperatures above approximately 500°C causes a phase change to rutile, however the phase change is often accompanied by crystal growth that results in undesirable scatter properties in the film. Deposition of mixed rutile and anatase films is particularly undesirable in that the index of such mixtures is difficult to predict and control, leading to poor optical performance in the coating.

Previous attempts to deposit rutile titanium dioxide have utilized techniques such as heating the substrates to high temperatures, use of ion beam sputtering, or RF sputtering. Heating the substrates to the temperature required to form rutile titanium dioxide is often impractical in manufacturing, and in many cases the heat will physically damage the substrates. RF sputtering and ion beam sputtering allow the formation of films composed substantially of rutile titanium dioxide at temperatures less than 200°C, however, the deposition rate is slow and thus economically impractical and, in the case of ion beam sputtering, the area coated is small and thus economically impractical.

For these reasons use of titanium dioxide in optical coatings has been mostly limited to deposition of the lower index anatase phase and applications where the temperature at which the film must perform is low.

The present invention in one aspect provides for the deposition of thin films of titanium dioxide that are substantially composed of rutile titanium dioxide on one or more substrates at higher rates, lower absorption, and lower temperatures than have been heretofore possible. The coating process and system may provides for the deposition of titanium dioxide in successive monolayers from a target operating primarily in the metallic mode. The term"monolayer"as used herein means a layer of material that is no more than one atom in thickness. Depositing a monolayer does not mean that the entire surface on which the monolayer is deposited are covered by atoms of the deposited material, but only that the material deposited is no more than one atom in thickness. Each newly deposited monolayer is fully oxidized under conditions resulting in the formation of rutile titanium dioxide before the next monolayer is deposited over the previous layer. The deposition process is performed at moderate temperatures and at rates that are significantly faster than those of other coating techniques.

Accordingly, it is an object of the present invention to obviate many of the above problems in the prior art and to provide a novel apparatus and process for high rate deposition of thin films of rutile titanium dioxide. These and many other objects and advantages of the present invention will be readily apparent to one skilled in the art to which the invention pertains from a perusal of the claims, the appended drawings, and the following detailed description of various embodiments.

The present invention provides a method for forming a thin film on a substrate according to claim 1. Preferred embodiments are defined in the dependent claims.

### BRIEF DESCRIPTION OF THE DRAWINGS

Figure 1 is a phase diagram for thin films of vacuum deposited titanium dioxide taken from P. Lobl, Thin Solid Films 251,72-79 (1994).
Figure 2 is a schematic representation of a coating system according to one aspect of the present invention.
figure 3 is an illustration of the measured compared to theoretical transmittance vs. wavelength of a thin film formed according to one aspect of the present invention.
Figure 4 is an illustration of the measured compared to theoretical transmittance vs. wavelength of a thin film formed according to another aspect of the present invention.

### DESCRIPTION

With reference to the drawings, like numerals represent like components throughout the several drawings.

The present invention is directed to systems and processes for forming thin films of titanium dioxide formed in substantially all rutile phase. In one aspect, the invention is directed to reactive sputter coating systems and processes for forming thin films of rutile titanium dioxide. The system includes a sputtering chamber having one or more coating stations and a means for mounting and moving one or more substrates through the coating stations. The system and process may include a batch coating process wherein the mounting and moving means comprises a rotatable drum, table, disk, or other transporting device of suitable geometry. A reactive coating system and process suitable for forming thin films of rutile titanium dioxide is disclosed in U.S. Patent No. 5,849,162 to Bartolomei et.al., the content of which is incorporated herein by reference.

The sputtering chamber includes one or more coating stations. At least one sputtering target is positioned in the coating station. In one aspect, the target comprises a magnetron sputtering device. The target is operated at a power sufficient to create a reactive atmosphere in the coating station and to plasma sputter titanium or an oxide of titanium onto the substrates that are moved through the coating station on the mounting and moving means.

A plasma generating device is also positioned in the coating station adjacent the target. In one aspect, the plasma generating device comprises a microwave generator. The plasma generator is operated at a power level for generating a plasma in the coating station that interdiffuses with the plasma generated by the target to increase the area, density, and reactivity of the reactive atmosphere in the coating station.

In one aspect, the present invention provides direct deposition of rutile titanium dioxide films at relatively low substrate temperatures by providing energy to the growing film in several forms. The energy is provided by a combination of the magnetron target plasma and the plasma generated by the plasma generating device. The present invention forms thin films of rutile titanium dioxide films that are essentially stochiometric as formed. This is accomplished by introduction of oxygen into the adjacent plasma, and by relatively rapid translation of the substrates into and out of close proximity to the target surface in the coating station. On each successive pass by the target a monolayer of titanium is deposited and then completely oxidized at energies sufficient to form rutile titanium dioxide. This oxidation of the film is accomplished before the substrate passes by the target once again and acquires a fresh layer of titanium metal.

In one embodiment, the adjacent plasma is of sufficient intensity to provide significant quantities of monatomic oxygen. Exposing the deposited titanium to monatomic oxygen permits the complete oxidation of the titanium being deposited without having to operate the target(s) in a poisoned mode and suffer the resulting large decrease in deposition rate. Previous attempts to deposit titanium dioxide at high rates suffered from this inability to completely oxidize the film, with the result that the deposited films were unacceptably absorbing. Without the adjacent plasma, the oxygen available to react with the freshly deposited titanium metal on the substrate surface is mainly diatomic in nature. To form titanium dioxide by reacting diatomic oxygen and titanium requires a high activation energy. Due to the high activation energy, the titanium is not completely oxidized.

In one aspect of the present invention, the plasma generating device provides a plasma containing monatomic oxygen which reacts much more easily with the titanium metal. Thus it is possible to completely oxidize the film and obviate the disadvantages of forming absorbing films.

The provision of monatomic oxygen to the growing film is important for the rapid and complete oxidation of the titanium atoms on the substrate surface, but it also has another benefit because it provides more energy to the growing film. This increased energy is provided by the heat of reaction of the monatomic oxygen with the titanium atoms, as compared to the lower heat of reaction that would be provided by reaction of the titanium atom with diatomic, molecular oxygen. Reaction of a diatomic oxygen molecule with a titanium atom requires at least formally that the oxygen molecule first be split into monatomic oxygen. This is a highly endothermic reaction, and the necessary energy for splitting the oxygen molecule is subtracted from the energy released by reaction of the oxygen atom and the titanium atom, giving a lower net energy release for the reaction of diatomic oxygen with titanium as compared to the reaction of monatomic oxygen atoms with titanium.

It is often desirable to operate the titanium target(s) in a substantially metallic mode so that material sputtered from the target consists primarily of titanium atoms. The oxygen is introduced into the adjacent plasma to provide activated oxygen species that fully oxidize the deposited titanium atoms. The energy released on oxidation of the titanium atoms contributes to the energy necessary to from the titanium dioxide in the rutile phase. Methods for control of the target oxidation state while maintaining a high sputtering rate are disclosed in U.S. Patent No. 5,849,162.

In many situations it may be desirable to provide at least one additional coating station equipped with targets that permit sputtering of materials other than titanium. By alternating use of the coating stations, the present invention provides for the formation of multilayer coatings in which at least one of the layers is composed of substantially rutile titanium dioxide. It may also be desirable to provide more than one coating station capable of sputtering titanium in order to increase the overall deposition rate of rutile titanium dioxide on the substrates.

In one aspect of the present invention, balanced magnetrons are operated from an a.c. power supply. The use of an a.c. power supply aids in the formation of rutile titanium dioxide. In an a.c. sputtering system the power switches back and forth between the two targets, with each target alternately acting as the cathode and then the anode in the course of one cycle of power. At the frequencies used, the plasma decays significantly when the power is switched between the two targets (a time on the order of a few tens of microseconds), meaning that the plasma must be restruck over the target that is operating as the cathode. This higher energy needed to restrike the plasma over the target results in a higher electron temperature for the sputtering plasma, resulting in a higher sheath voltage around the substrate as it passes through the plasma. This in turn causes a higher energy ion bombardment of the substrate. This higher energy bombardment facilitates both the oxidation of the titanium atoms deposited on the substrate and the formation of the rutile titanium dioxide.

Other a.c. powered configurations and other power supplies may also be used to provide the higher electron temperature in the plasma to aid the formation of rutile titanium dioxide. Unbalanced a.c. magnetrons, as well as a pulsed d.c. magnetron, also require restriking of the plasma over the target and thus provide the benefit of higher electron temperatures in the plasma. The a.c. configurations also have the advantage that each target functions alternately as the anode and then the cathode so that the targets are kept clean of oxide buildup on their surface and the anode is never lost. In pulsed d.c. systems, only one target is present and it is always the cathode, making.it easier for wandering anode problems to occur in the chamber. Other power supplies and target configurations may be used, although with some loss of rate and film quality.

It will often be advantageous, in order to provide coating of many substrates within one operation, to provide a system with relatively long sputtering targets, an elongated plasma generator, and a substrate holder capable of holding a large number of substrates.

It may also be desirable to provide a method for secondary movement of the substrate(s) with respect to the transporting device to improve uniformity of deposition on the substrate(s). For example, the substrate could be rotated about its center point, translated across some aspect of the transporting device, or some combination of these without departing from the current invention. U.S. Patent No. 6,485,646 discloses a coating system wherein a secondary movement is provided to the substrates to improve uniformity of the coating on the substrates and among an array of substrates.

The present invention provides a system and process for forming thin films of rutile titanium dioxide with low absorption, at high rates, and low temperatures, the combination of which has heretofore been unrealized using reactive sputtering systems. Unlike ion beam sputtering, this process can be carried out on a relatively large throughput of substrates. The combination of high deposition rates and multiple substrates makes the current invention of great economic advantage in the manufacture of articles with rutile titanium dioxide coatings, such as multilayer optical coatings. It also makes titanium dioxide a usable coating material in applications where it would previously have not been feasible.

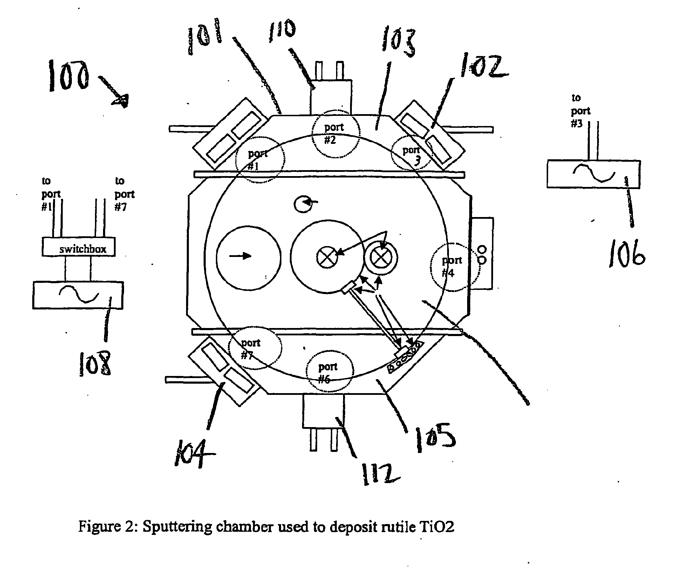

Figure 2 is a schematic illustration of a reactive coating system according to one aspect of the present invention. With reference to Figure 2, the coating system 100 includes a chamber 101 having two coating stations 103 and 105. The titanium cathode pair 102 is positioned in coating station 103 and is powered from the a.c. power supply 106. The titanium cathode pair 104 is positioned in coating station 105 and is powered by a.c. power supply 108. The a.c. power supplies may be operated at any suitable frequency, but generally between 10 kHz and 100 kHz. The plasma generating device 110 is positioned in coating station 103 adjacent the cathode pair 102. The plasma generating device 112 is positioned in coating station 105 adjacent the cathode pair 104. The system may be operated by operating the targets and plasma generating devices in one coating station or in both coating stations simultaneously. The drum 114 provides the means for mounting and moving one or more substrates through the coating stations.

Oxygen is inlet into the chamber at the same port as the plasma generating devices 110, 112. This configuration may also provide for the secondary rotation of the substrates, which rotation rate is independent of the drum rotation rate.

### Example:

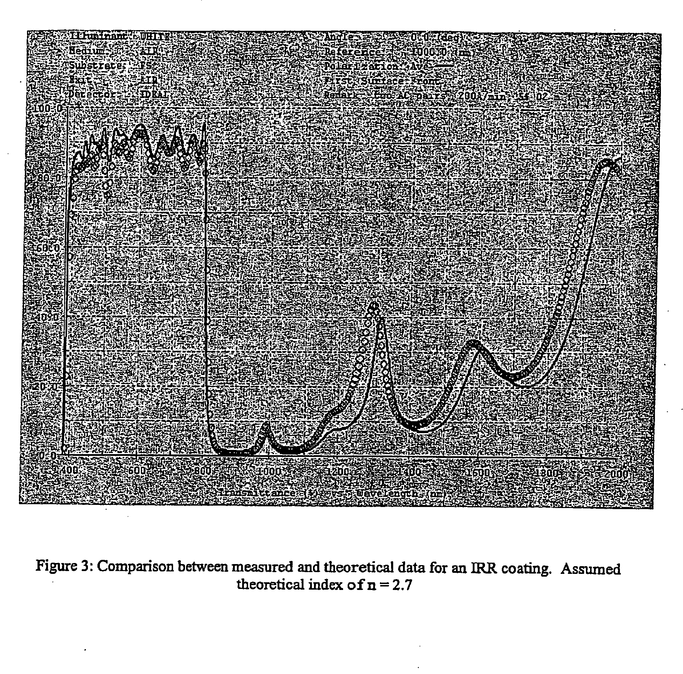

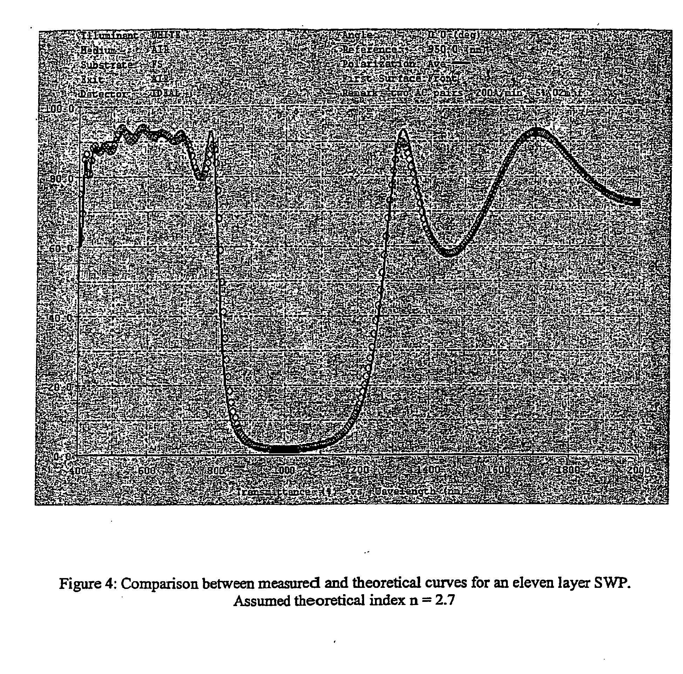

A coating system configured as shown in Figure 2 was used to form (i) an IRR (Infrared Red Reflector) coating and (ii) an eleven layer SWP (short wave pass) coating. The a.c. power supplies 106 and 108 were operated at 65 kHz and 40 kHz respectively. The measured results for these two coatings, as compared to theoretical predictions is shown in Figures 3 and 4 respectively. The theoretical curves were calculated assuming the use of rutile titanium dioxide with an index of 2.7 @ 550 nm. The measured results show coatings having rutile titanium dioxide with low absorption were formed using the system and process shown in Figure 2. Measured rates show that the.titanium dioxide was deposited at a rate of 10 nm/min using one a.c. cathode pair, and at as rate of 20 nm/min if both titanium cathode pairs were operated simultaneously. The coatings exhibited an absorption with a k value of less than 10 x 10⁻⁴ after baking the substrates at about 500°C for about one hour.

While preferred embodiments of the present invention have been described, it is to be understood that the embodiments described are illustrative only and that the scope of the invention is to be defined solely by the appended claims when accorded a full range of equivalence, many variations and modifications naturally occurring to those of skill in the art from a perusal hereof.

## Claims

1. A process for forming a thin film on a substrate comprising the steps of depositing titanium on the substrate and exposing the deposited titanium to monatomic oxygen, the process comprising the steps of depositing titanium in a monolayer and oxidizing all of the deposited titanium forming a film consisting of rutile titanium dioxide.

2. The process of Claim 1 wherein the steps of depositing and oxidizing the monolayer of titanium are repeated to obtain a predetermined thickness of a thin film consisting of rutile titanium dioxide.

3. The process of one of the preceding claims wherein the monolayer of titanium is sputtered onto the substrate.

4. The process of Claim 1 wherein the temperature of the substrate is less than 200°C.

5. The process of Claim 1 wherein the thin film is exposed to a temperature greater than 400°C.

6. The process of Claim 5 wherein the thin film is exposed to a temperature of 500°C.

7. The process of one of the preceding claims wherein the step of oxidizing comprises commingling an auxiliary plasma with a sputtering plasma and exposing the deposited titanium to the commingled plasma.

8. The process of one of the preceding claims comprising the steps of:
moving one or more substrates past a sputtering target;
sputter depositing a monolayer of titanium on the substrates during a single pass of the substrates past the target; and
oxidizing all of the deposited titanium to form titanium dioxide in the rutile phase.

9. The process of Claim 8 wherein the step of sputter depositing comprises operating the target from an a.c. power source.

## Patentansprüche

1. Verfahren zum Ausbilden eines Dünnfilms auf einem Substrat, wobei Titan auf dem Substrat abgeschieden und das abgeschiedene Titan einatomischen Sauerstoff ausgesetzt wird, wobei das Verfahren die folgenden Schritte umfasst:
Abscheiden von Titan in einer Monoschicht und Oxidieren des gesamten abgeschiedenen Titans, um einen Film zu bilden, der aus Rutil-Titan-Dioxid besteht.

2. Verfahren nach Anspruch 1, wobei die Schritte des Abscheidens und Oxidierens der Monoschicht aus Titan wiederholt werden, um eine vorgegebene Dicke eines Dünnfilms zu erhalten, der aus Rutil-Titan-Dioxid besteht.

3. Verfahren nach einem der vorangehenden Ansprüche, wobei die Monoschicht aus Titan auf das Substrat gesputtert wird.

4. Verfahren nach Anspruch 1, wobei die Temperatur des Substrats geringer als 200°C ist.

5. Verfahren nach Anspruch 1, wobei der Dünnfilm einer Temperatur von mehr als 400°C ausgesetzt wird.

6. Verfahren nach Anspruch 5, wobei der Dünnfilm einer Temperatur von 500°C ausgesetzt wird.

7. Verfahren nach einem der vorangehenden Ansprüche, wobei der Schritt des Oxidierens das Vermischen eines Hilfsplasmas mit einem Sputter-Plasma umfasst, wobei das abgeschiedene Titan dem vermischten Plasma ausgesetzt wird.

8. Verfahren nach einem der vorangehenden Ansprüche, mit den weiteren Schritten:
Vorbeibewegen eines oder mehrerer Substrate an einem Sputter-Target;
Sputter-Abscheiden einer Monoschicht aus Titan auf dem Substrat während eines einzelnen Durchgangs des Substrats an dem Target vorbei; und
Oxidieren des gesamten abgeschiedenen Titans, um Titan-Dioxid in der Rutil-Phase zu bilden.

9. Verfahren nach Anspruch 8, wobei der Schritt des Sputter-Abscheidens das Betreiben des Targets mit einer Wechselstromquelle umfasst.

## Revendications

1. Procédé pour former un film mince sur un substrat, comprenant les étapes consistant à déposer du titane sur le substrat et exposer le titane déposé à de l'oxygène monoatomique, le procédé comprenant les étapes consistant à déposer du titane en une monocouche et oxyder la totalité du titane déposé pour former un film constitué de dioxyde de titane de rutile.

2. Procédé selon la revendication 1, dans lequel les étapes de dépôt et d'oxydation de la monocouche de titane sont répétées pour obtenir une épaisseur prédéterminée d'un film mince constitué de dioxyde de titane de rutile.

3. Procédé selon l'une quelconque des revendications précédentes, dans lequel la monocouche de titane est pulvérisée sur le substrat.

4. Procédé selon la revendication 1, dans lequel la température du substrat est inférieure à 200°C.

5. Procédé selon la revendication 1, dans lequel le film mince est exposé à une température supérieure à 400°C.

6. Procédé selon la revendication 5, dans lequel le film mince est exposé à une température de 500°C.

7. Procédé selon l'une quelconque des revendications précédentes, dans lequel l'étape d'oxydation comprend le fait de mélanger un plasma auxiliaire avec un plasma de pulvérisation et d'exposer le titane déposé au plasma mélangé.

8. Procédé selon l'une quelconque des revendications précédentes comprenant les étapes suivantes :
déplacer un ou plusieurs substrats au-delà d'une cible de pulvérisation ;
déposer par pulvérisation une monocouche de titane sur les substrats pendant une unique passe des substrats au-delà de la cible ; et
oxyder la totalité du titane déposée pour former du dioxyde de titane dans la phase de rutile.

9. Procédé selon la revendication 8, dans lequel l'étape de dépôt par pulvérisation comprend le fait d'actionner la cible à partir d'une source d'énergie en courant alternatif.
